(19) Europäisches Patentamt
European Patent Office
Office européen des brevets

(11) **EP 2 961 069 B1**

(12) **EUROPEAN PATENT SPECIFICATION**

(45) Date of publication and mention
of the grant of the patent:
**25.11.2020 Bulletin 2020/48**

(51) Int Cl.:
**H03K 17/16** *(2006.01)*      *H03K 17/082* *(2006.01)*
**H02M 1/08** *(2006.01)*

(21) Application number: **15173987.7**

(22) Date of filing: **26.06.2015**

(54) **ELECTRIC MACHINE SYSTEM AND IGBT SWITCH CIRCUIT THEREOF**

ELEKTRISCHES MASCHINENSYSTEM UND IGBT-SCHALTER DAFÜR

SYSTÈME DE MACHINE ÉLECTRIQUE ET SON CIRCUIT DE COMMUTATION À GRILLE ISOLÉE (IGBT)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.06.2014 CN 201410302818**

(43) Date of publication of application:
**30.12.2015 Bulletin 2015/53**

(73) Proprietor: **Siemens Aktiengesellschaft
80333 München (DE)**

(72) Inventors:
• **Liu, Bo
200245 Shanghai (CN)**
• **Shan, Liang
200245 Shanghai (CN)**
• **Yu, Jing
200245 Shanghai (CN)**
• **Zhuang, Zhao Hui
200136 Shanghai (CN)**

(74) Representative: **Patentanwaltskanzlei WILHELM
& BECK
Prinzenstraße 13
80639 München (DE)**

(56) References cited:
**EP-A1- 1 962 412         US-A1- 2006 103 428
US-A1- 2009 296 291       US-A1- 2013 293 287**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**Technical field**

The present invention relates to the field of electrically driven motor vehicles, in particular to an electric machine system for an electrically driven motor vehicle and an IGBT switch circuit thereof.

**Background art**

An electrically driven motor vehicle is a new type of vehicle, in which a vehicle-mounted power supply provides motive power, and the wheels are driven to travel by an electric machine. Compared with conventional motor vehicles, electrically driven motor vehicles have very little effect on the environment, and for this reason are widely regarded as having favorable prospects. At the present time, there are also hybrid motor vehicles on the market, in which an electrically driven motor vehicle is combined with a conventional motor vehicle. Such a vehicle is fitted with two or more motive power source systems, e.g. a hybrid motor vehicle with an internal combustion engine vehicle generator and a storage battery.

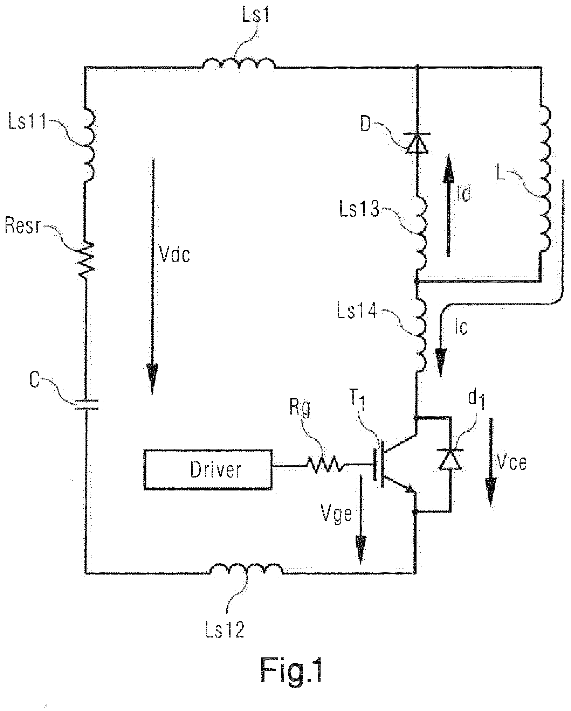

In the electrical driving system of a hybrid or electrically driven motor vehicle, an IGBT (Insulated Gate Bipolar Transistor) is often used to drive an electric machine system, so as to drive the motor vehicle. In other words, an IGBT circuit may be regarded as a high-frequency modulating switch between the electric machine system and the motor vehicle for adjusting duty cycle. Fig. 1 shows a structural schematic diagram of an IGBT circuit according to the prior art. As Fig. 1 shows, the IGBT circuit is formed by the combination of an IGBT $T_1$ and a diode $d_1$ connected in parallel. When the IGBT needs to switch off, i.e. when the electric machine system needs to disconnect the supply of electric power with the tires of the electrically driven motor vehicle, the input voltage (i.e. the voltage between the gate and emitter of the IGBT $T_1$) $V_{ge}$ in the IGBT circuit will suddenly decrease. Due to connecting lines/connecting elements in the system, parasitic inductance will arise in each circuit branch, e.g. parasitic inductance $ls_{11}$, parasitic inductance $ls_{12}$, parasitic inductance $ls_{14}$ and parasitic inductance $ls_{13}$, as shown in Fig. 1. At this point, the parasitic inductance $ls_{11}$, parasitic inductance $ls_{12}$, parasitic inductance $ls_{14}$ and parasitic inductance $ls_{13}$ of the branches will give rise to an induced voltage due to the sharp change in input current $I_c$, thereby affecting the output voltage of the IGBT $T_1$. This is because:

$$V_{induced\ voltage} = L_{parasitic\ inductance} \cdot \Delta I_c$$

where $L_{parasitic}$ inductance is the equivalent value of parasitic inductance of the parasitic inductance $ls_{11}$, parasitic inductance $ls_{12}$, parasitic inductance $ls_{14}$ and parasitic inductance $ls_{13}$ of the branches. When the current change rate $\Delta I_c$ increases, the $V_{induced}$ voltage of the parasitic inductance increases, thereby causing the input voltage of the IGBT $T_1$ to increase. Thus, in accordance with the characteristics of a IGBT, the output voltage $V_{ce}$ of the IGBT $T_1$ (i.e. the voltage between the emitter and collector of the IGBT $T_1$) will experience a spike.

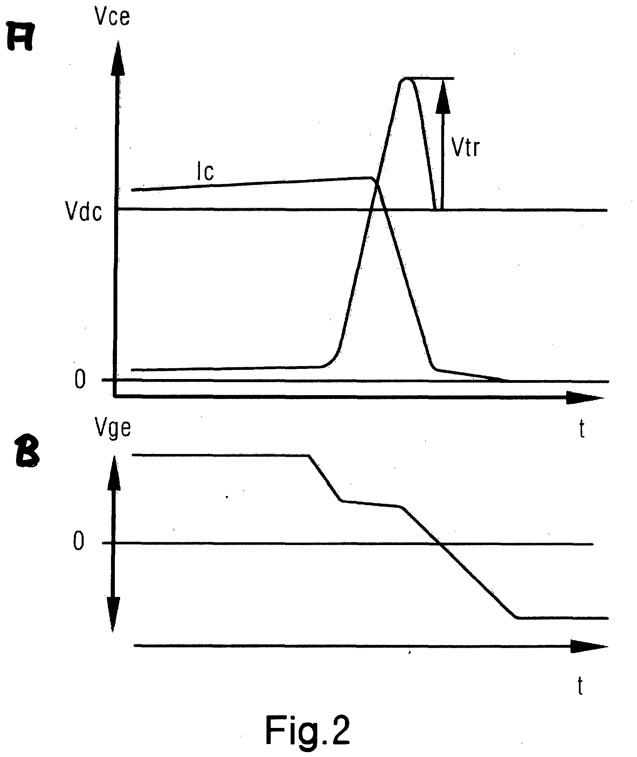

Fig. 2(a) is a graph of output voltage of an IGBT circuit according to the prior art, wherein the horizontal coordinates represent time, and the vertical coordinates represent the output voltage $V_{ce}$ of the IGBT circuit, i.e. the voltage between the emitter and collector of the IGBT $T_1$. Fig. 2(b) is a graph of input voltage of an IGBT circuit in the prior art, wherein the horizontal coordinates represent time, and the vertical coordinates represent the input voltage of the IGBT circuit, i.e. the voltage $V_{ge}$ between the gate and emitter of the IGBT $T_1$. $I_c$ is the input current of the IGBT $T_1$, i.e. the current which flows in from the collector of the IGBT $T_1$. The time axis of Fig. 2(a) corresponds to the time axis of Fig. 2(b). According to the characteristics of a IGBT, the output voltage of the IGBT $T_1$ is:

$$V_{ce} = V_{dc} + V_{tr}$$

where $V_{dc}$ represents the bus voltage, i.e. the total voltage of the system. $V_{tr}$ represents the spike voltage of the IGBT $T_1$. As Figs. 2(a) and Fig. 2(b) show, at approximately time $t_1$, the electric machine system 200 begins to disconnect the supply of electric power with the electrically driven motor vehicle 100, and the input voltage $V_{ge}$ at the IGBT $T_1$ decreases, i.e. the input current $I_c$ of the IGBT $T_1$ begins to decrease. At this point, as Fig. 2(b) shows, $V_{tr}$ reaches a very high value, so that Vce overvoltage damages the IGBT circuit.

Thus, in the industry, a protection circuit will generally be provided for the IGBT circuit, but the provision of a protection circuit will give rise to new problems.

From US2009/296291A1 an IGBT switch circuit with the features of the first part of claim 1 is known.

US2013/293287A1 discloses a similar IGBT switch circuit. US 2006/103428 discloses an IGBT switch circuit having a clamping circuit being controlled in an active state.

**Content of the invention**

The present invention provides an IGBT switch circuit as claimed in claim 1 and an electric machine system as claimed in claim 6. Preferred embodiments are disclosed in the subclaims..

One aspect of the present invention provides an IGBT switch circuit, wherein the IGBT switch circuit comprises: an IGBT circuit and a first diode, the IGBT circuit serving as a modulating switch between an electric machine and a load thereof; an active clamping protection circuit coupled to the IGBT circuit; with a switch also being connected between the IGBT circuit and the protection circuit. The solution can solve the problem of damage to the IGBT caused by overvoltage at the output of the IGBT in the IGBT when the IGBT is switched off. Moreover, the solution can also solve the technical problem whereby, when the electric machine is back-dragged to a maximum speed, the electric machine becomes a generator and produces very high reverse potential, increasing the bus voltage to an overvoltage state, and finally causing the voltage across the collector and emitter of the IGBT to reach an opening voltage of the active clamping circuit serving as the protection circuit, possibly causing the IGBT to be switched on erroneously or the active clamping circuit to be damaged.

Furthermore, the IGBT is an N-channel IGBT. Furthermore, the protection circuit comprises a transient suppression diode and a second diode connected in series. The protection circuit uses the reverse breakdown characteristic of the transient suppression diode, for clamping the point potential.

Furthermore, the switch comprises a PMOS, with a source thereof connected to the second diode of the protection circuit, and a drain thereof connected to a gate of the IGBT of the IGBT circuit. The present invention uses the period characteristic of the PMOS, to realize a switch function.

Furthermore, the switch is also connected to an NMOS, with a drain thereof coupled to a gate of the PMOS serving as the switch, and a source thereof connected to ground. Since a control signal cannot be transmitted directly to the switch, a buffer function for level matching must be served.

Furthermore, the IGBT switch circuit also comprises a gate level driver connected to a gate of the NMOS, for driving the IGBT circuit.

Furthermore, a resistance circuit is also connected between the gate level driver and the gate of the NMOS, for controlling the drive speed of the IGBT circuit.

Furthermore, the switch circuit also comprises a control circuit, which issues a control signal to control the opening and closing of the switch.

Furthermore, the control signal is a square wave signal of a specific frequency, which controls the switch to remain closed when the electricity supply of the electric machine and the load thereof is disconnected. When the IGBT circuit is switched on, the switch is controlled to conduct electricity, and the protection circuit operates normally. When a first IGBT circuit is switched off, the switch maintains a closed state (is at a HIGH level) for a period of time, to ensure that the protection circuit operates normally in order to effectively suppress a spike value, then the switch turns off, so that the IGBT circuit is not erroneously switched on and thereby damaged by a reverse potential overvoltage.

A second aspect of the present invention provides an electric machine system, wherein the electric machine system comprises an electric machine for driving a load, wherein at least three branches are included, each branch being connected to two parallel-connected IGBT switch circuits according to the first aspect of the present invention.

A third aspect of the present invention provides an electrically driven motor vehicle, wherein it comprises an electric machine system according to the second aspect of the present invention.

**Description of the accompanying drawings**

Embodiments of the present invention are described in detail below with reference to the accompanying drawings, wherein:

Fig. 1 is a structural schematic diagram of an IGBT switch circuit in the prior art;

Fig. 2(a) is a graph of output voltage of an IGBT circuit in the prior art;

Fig. 2(b) is a graph of input voltage of an IGBT circuit in the prior art;

Fig. 3 is a schematic diagram of the modular structure of an electric machine system according to a particular embodiment of the present invention;

Fig. 4 is a schematic diagram of the connection between the electric machine system and IGBT switch circuit according to a particular embodiment of the present invention;

Fig. 5 is a circuit connection diagram of an IGBT circuit and a protection circuit thereof according to an example of prior art;

Fig. 6(a) is a graph of output voltage of an IGBT circuit;

Fig. 6(b) is a graph of input voltage of an IGBT circuit;

Fig. 7 is a circuit structure diagram of an IGBT switch circuit according to a particular embodiment of the present invention;

Fig. 8 is a waveform diagram of control signals issued by a control circuit of an IGBT switch circuit according to a particular embodiment of the present invention.

**Particular embodiments**

Particular embodiments of the present invention are explained below in conjunction with the accompanying drawings.

The following description takes as an example the application of the electric machine system and IGBT switch circuit thereof to the field of electrically driven motor vehicles, wherein the electric machine system is used to provide electric power for the tires of an electrically driven motor vehicle, so that the tires of the electrically driven motor vehicle acquire motive power to drive the motor vehicle to travel, and the IGBT switch circuit is used to drive the electric machine system to provide electric power for the tires of the electrically driven motor vehicle. However, those skilled in the art should realize that all applications which are capable of an electric machine system and require the provision of a drive circuit between the electric machine system and the load should also be included in the scope of protection of the present invention.

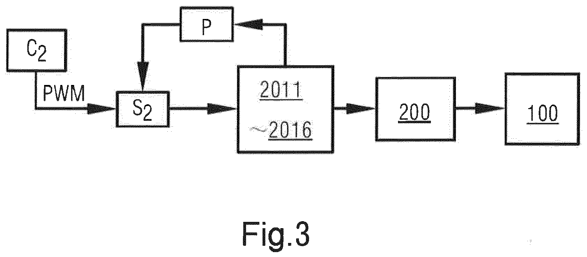

First of all, an outline is given of the connection between the electric machine system provided by the present invention and a load, as well as the internal modules of the electric machine system. Fig. 3 is a schematic diagram of the modular structure of an electric machine system according to a particular embodiment of the present invention. As Fig. 3 shows, an electric machine 200 supplies electricity to an electrically driven motor vehicle 100 by means of torque control, so that the electrically driven motor vehicle 100 converts electric power to motive power for the rotation of the wheels. An IGBT circuit serves as a switch between the electric machine 200 and the electrically driven motor vehicle 100; according to a preferred embodiment of the present invention, the IGBT circuit comprises a first IGBT circuit 2011, a second IGBT circuit 2012, a third IGBT circuit 2013, a fourth IGBT circuit 2014, a fifth IGBT circuit 2015 and a sixth IGBT circuit 2016. It must be explained that the number of IGBT circuits is determined according to the electric machine 200; a detailed explanation is given below. In the present invention, a circuit downstream of the IGBT circuit is provided with a switch $S_2$, which is driven by a control signal PWM sent by a control circuit $C_2$. The IGBT circuit is also connected to a protection circuit P, used to protect the IGBT circuit from the effects of overvoltage.

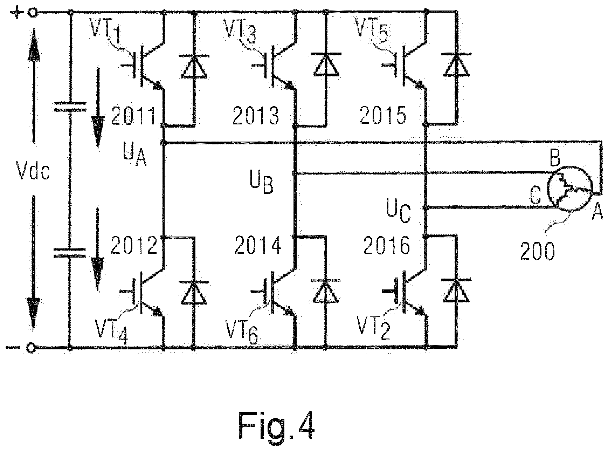

First of all, a general introduction to the connection between the electric machine system and the IGBT switch circuit is given. Fig. 4 is a schematic diagram of the connection between the electric machine system and IGBT switch circuit according to a particular embodiment of the present invention. Electric machines (motors) in common use in the industry at the moment generally have three branches, as Fig. 4 shows; according to a particular embodiment of the present invention, the electric machine M has three branches, namely a first branch A, a second branch B and a third branch C. Since a bus voltage Udc provided by a system power supply has two directions (positive and negative), the first branch A, second branch B and third branch C each require two IGBT circuits. Specifically, as Fig. 4 shows, the first branch A is connected to the first IGBT circuit 2011 and second IGBT gate level 2012 which are connected in parallel, wherein the first IGBT circuit 2011 is connected to a positive pole of the bus voltage, and the second IGBT circuit 2012 is connected to a negative pole of the bus voltage; the second branch B is connected to the third IGBT circuit 2013 and fourth IGBT gate level 2014 which are connected in parallel, wherein the third IGBT circuit 2013 is connected to the positive pole of the bus voltage, and the fourth IGBT circuit 2014 is connected to the negative pole of the bus voltage; the third branch C is connected to the fifth IGBT circuit 2015 and sixth IGBT circuit 2016 which are connected in parallel, wherein the fifth IGBT circuit 2015 is connected to the positive pole of the bus voltage, and the sixth IGBT circuit 2016 is connected to the negative pole of the bus voltage. When the electric machine is operating, positive-direction or negative-direction voltages arise in the first branch A, second branch B and third branch C, and voltages in opposite directions at least arise in two of the first branch A, second branch B and third branch C, so that the electric machine obtains an AC voltage, thereby supplying electric power for the tires of the electrically driven motor vehicle, so that the tires of the electrically driven motor vehicle acquire motive power for rotation in order to drive the motor vehicle to travel.

Those skilled in the art should understand that although an explanation is given herein using the example of the electric machine comprising three branches, the present invention is not limited to this; the scope of application thereof includes electric machine systems with at least three branches.

The present invention is explained below, taking the IGBT switch circuit connected to the first branch A in the electric machine shown in Fig. 4 as an example.

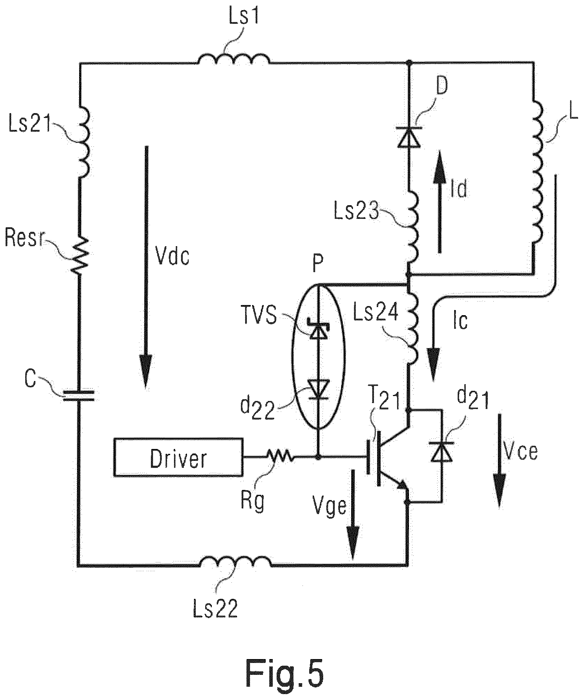

Fig. 5 is a circuit connection diagram of an IGBT circuit and a protection circuit thereof according to an example of prior art. The inductance L in Fig. 5 is equivalent to an inductance L in the electric machine 200 in Fig. 4; the IGBT circuit shown in Fig. 5 is equivalent to one of the IGBT circuits connected in parallel with the first branch A in Fig. 5, e.g. the first IGBT circuit 2011. Referring to Figs. 4 and 5, a first aspect of the present invention provides an IGBT switch circuit, wherein the IGBT switch circuit comprises a first IGBT circuit 2011, which consists of an IGBT $T_{21}$ and a first diode $d_{21}$ connected in parallel; the first IGBT circuit 2011 serves as a high-frequency modulating switch between the electric machine system and the motor vehicle for adjusting duty cycle. In this case, the load is an electrically driven motor vehicle by way of example. The IGBT switch circuit provided by the present invention is also specially provided with a protection circuit P for the first IGBT circuit 2011; the protection circuit P is an active clamping circuit, comprising a transient suppression diode TVS and a second diode $d_{22}$, which are reverse-connected in series. Those skilled in the art will realize that the transient suppression diode is also called a clamping diode, and is a highly efficient circuit protection device that is widely used in the industry at present, which can absorb power surges up to several kilowatts. The main characteristic of the transient suppression diode TVS is that it experiences reverse breakdown and begins conducting as soon as a reverse voltage exceeds a rated value, thereby allowing the passage of a large current while clamping the voltage at a preset level.

Specifically, as mentioned above, since the input voltage $V_{ge}$ of the IGBT $T_{21}$ in the first IGBT circuit 2011 falls when the electrical connection between the electric machine and the electrically driven motor vehicle is broken, the input current $I_c$ thereof also falls; at this point, the parasitic inductance $Ls_{21}$, parasitic inductance $Ls_{22}$, parasitic inductance $Ls_{23}$ and parasitic inductance $Ls_{24}$ give rise to an induced voltage due to a change in the change rate of the input current $I_c$; the induced voltage acts on the IGBT $T_{21}$ in the first IGBT circuit 2011, causing a very large value (spike value) in the output voltage of the IGBT $T_{21}$ and thereby damaging the IGBT circuit. The protection circuit P is provided precisely in order to solve this problem. Specifically, when induction by the parasitic inductance gives rise to an induced voltage, this is equivalent to an increase in the reverse voltage of the transient suppression diode TVS, and when the reverse voltage exceeds a rated value, the transient suppression diode TVS experiences reverse breakdown and begins conducting. Since the protection circuit P is connected to the gate of the IGBT $T_{21}$, the gate potential $V_g$ of the IGBT $T_{21}$ increases, so that the input voltage $V_{ge}$ of the IGBT $T_{21}$ is compensated and increases, with a corresponding decrease in the output voltage $V_{ce}$, thereby avoiding damage to the IGBT circuit as a result of a very large value (spike value) occurring in the output voltage $V_{ce}$.

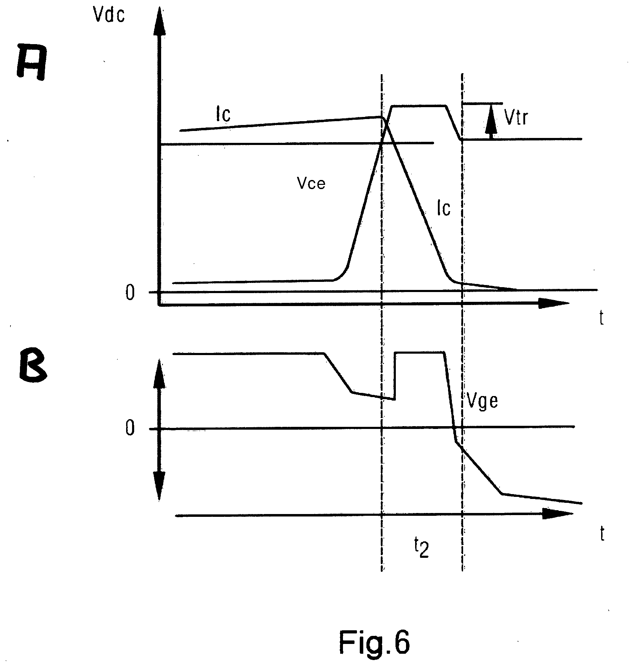

Fig. 6 (a) is a graph of output voltage of an IGBT circuit according to an example of prior art, wherein the horizontal coordinates represent time, and the vertical coordinates represent the output voltage $V_{ge}$ of the IGBT circuit, i.e. the voltage between the emitter and collector of the IGBT $T_{21}$. Fig. 6(b) is a graph of input voltage of an IGBT circuit according to an example of prior art, wherein the horizontal coordinates represent time, and the vertical coordinates represent the input voltage of the IGBT circuit, i.e. the voltage $V_{ge}$ between the gate and emitter of the IGBT $T_{21}$. $I_c$ is the input current of the IGBT $T_{21}$, i.e. the current which flows in from the collector of the IGBT $T_{21}$. The time axis of Fig. 6(a) corresponds to the time axis of Fig. 6(b). According to the characteristics of a IGBT, the output voltage of the IGBT $T_{21}$ is :

$$V_{ce} = V_{dc} + V_{tr}$$

where $V_{dc}$ represents the bus voltage, i.e. the total voltage of the system. $V_{tr}$ represents the spike voltage of the IGBT $T_{21}$. As Figs. 6(a) and Fig. 6(b) show, in time period $t_2$, the electric machine system begins to disconnect the supply of electric power with the electrically driven motor vehicle, and the input voltage $V_{ge}$ of the IGBT $T_{21}$ decreases. Due to the compensating effect of the protection circuit P on the gate potential of the IGBT $T_{21}$, $V_{ge}$ is pulled up during time period $t_2$, so that a very large value (spike value) will not occur in $V_{ce}$, avoiding the damage to the IGBT circuit which would be caused by such a spike.

However, such a design will give rise to new problems. For example, when the motor vehicle serving as the load is on a downhill slope, due to the high-speed rotation of the tires, at this time the electric machine is back-dragged to a maximum speed, causing the electric machine to become a generator, and producing very high reverse potential, thereby increasing the bus voltage to an overvoltage state, and finally causing the voltage across the collector and emitter of the IGBT $T_{21}$ of the IGBT circuit, i.e. the output voltage $V_{ge}$ thereof, to reach an opening voltage of the active clamping circuit serving as the protection circuit P, thereby causing the IGBT circuit to be switched on erroneously or the protection circuit P to be damaged.

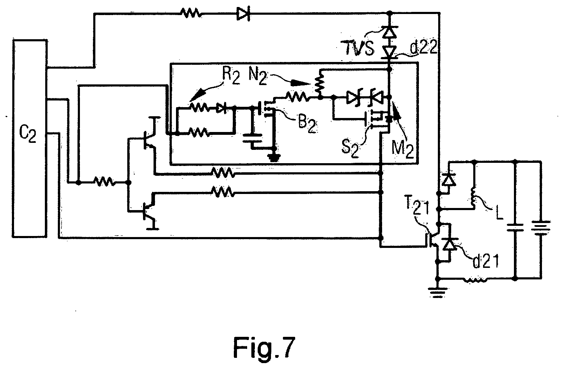

Thus, furthermore, in the present invention, a switch circuit 202 is also connected between the IGBT circuit 2011 and the protection circuit P. As Fig. 3 shows, furthermore, the switch circuit 202 comprises a switch $S_2$ and a control circuit $C_2$ which controls the switch. Specifically, as Fig. 7 shows, the switch $S_2$ is a MOSFET device PMOS by way of example, with a source thereof being connected to the second diode $d_{22}$ of the protection circuit, and the drain thereof being connected to an input end of the IGBT $T_2$ of the IGBT circuit. On the basis of the protection circuit P which is an active clamping circuit, the present invention adds a MOSFET device as a switch $S_2$ to control the switching on and off of the active clamping circuit function of the protection circuit P. As Fig. 3 shows, a switch control signal originates in a control signal PWM from a host computer control circuit $C_2$. When the first IGBT circuit 2011 is operating normally, the active clamping circuit function of the protection circuit P is controlled to be turned on, so the first IGBT circuit 2011 can effectively be protected from damage as a result of overvoltage. When the first IGBT circuit 2011 is switched off, the present invention can provide a voltage clamping function, preventing a dangerous overvoltage from occurring across the emitter and collector of the IGBT $T_{21}$ of the IGBT circuit. When the electric machine is back-dragged to a high speed, the host computer simultaneously switches off the IGBT drive signal and the active clamping circuit function of the protection circuit P by means of a command to switch off the control signal PWM.

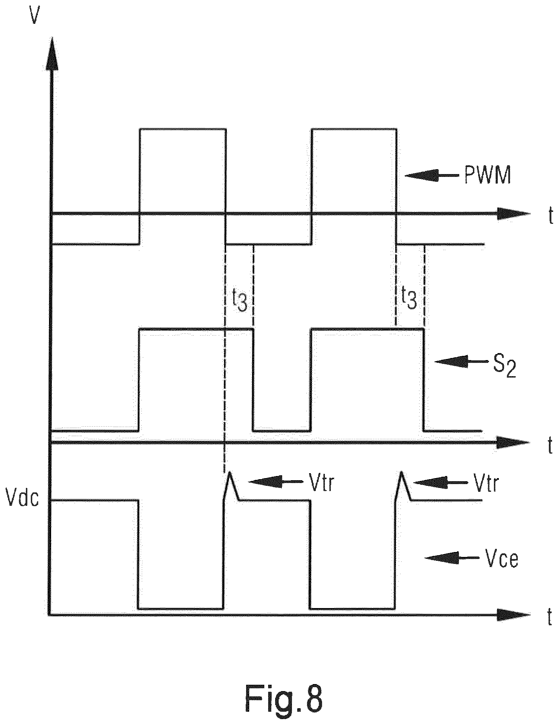

Fig. 8 is a waveform diagram of control signals issued by a control circuit of an IGBT switch circuit according to a particular embodiment of the present invention. The horizontal coordinates represent time, while the vertical coordinates represent voltage. The top waveform diagram in Fig. 8 is a waveform diagram of a control signal PWM issued by the control circuit $C_2$, and it can be seen that PWM is a square wave of a specific frequency. The middle waveform in Fig. 8 represents the switch $S_2$; a HIGH level of the switch $S_2$ represents a closed state, while a LOW level represents an open state. The bottom waveform graph in Fig. 8 represents the output voltage $V_{ge}$ of the first IGBT circuit 2011; the protrusion close to the wave peak of the waveform represents a spike value $V_{tr}$ of the output voltage $V_{ce}$. Thus, as the figure shows, when the first IGBT circuit 2011 is switched on, the switch $S_2$ is closed by the control circuit $C_2$, and the protection circuit P operates normally. In time period $t_3$, when the first IGBT circuit 2011 is switched off, the switch $S_2$ maintains a closed state (is at a HIGH level) for a period of time, to ensure that the protection circuit P operates normally in order to effectively suppress the spike value $V_{tr}$, then the switch $S_2$ turns off, so that the first IGBT circuit 2011 is not erroneously switched on and thereby damaged by a reverse potential overvoltage.

Furthermore, the switch is also connected to an NMOS, with the drain thereof connected to the gate of a PMOS serving as switch $S_2$, and the source thereof being connected to ground. The NMOS is denoted by the drawing label $B_2$ in Fig. 7; this is because the PWM signal cannot be transmitted directly to the switch $S_2$, but requires $B_2$ to serve a buffer function for level matching.

Furthermore, the IGBT switch circuit also comprises a gate level driver (not shown) connected to the NMOS gate, for driving the IGBT circuit.

Furthermore, a resistance circuit $R_2$ is also connected between the gate level drive circuit and the NMOS gate, for controlling the drive speed of the IGBT gate level.

In addition, a voltage regulating circuit $M_2$ is also connected in parallel with the switch $S_2$, for ensuring that the switch $S_2$ is not subjected to overvoltage. A drive circuit $N_2$ is also connected in the circuit upstream of the voltage regulating circuit $M_2$, to drive the switch $S_2$.

A second aspect of the present invention also provides an electric machine system, characterized in that the electric machine system comprises an electric machine 200 for providing electric power for a load, wherein at least three branches are included, each branch being connected to two parallel-connected IGBT switch circuits as described above.

In particular, the load is an electrically driven motor vehicle, and the electric machine 200 is used for providing electric power for rotation of the tires of the electrically driven motor vehicle, so that the tires acquire motive power for rotation.

Using the electric machine system and IGBT switch circuit thereof that are provided in the present invention, the problem of damage to the IGBT caused by overvoltage at the output of the IGBT in the IGBT when the IGBT is switched off can be solved. In addition, the present invention can also solve the technical problem whereby, when the electric machine is back-dragged to a maximum speed, the electric machine becomes a generator and produces very high reverse potential, increasing the bus voltage to an overvoltage state, and finally causing the voltage across the collector and emitter of the IGBT to reach an opening voltage of the active clamping circuit serving as the protection circuit, possibly causing the IGBT to be switched on erroneously or the active clamping circuit to be damaged.

Although the content of the present invention has been presented in detail by way of the preferred embodiments above, it should be recognized that the above description should not be regarded as limiting the present invention. A variety of substitutions and amendments to the present invention will be obvious to those skilled in the art after reading the above content. Thus, the scope of protection of the present invention should be defined by the attached claims. Moreover, no drawing labels in the claims should be regarded as restricting the claims involved; the word "comprises" does not exclude other devices or steps not set out in the claims or description; and words such as "first" and "second" are intended merely to indicate designations, not any specific order.

**Claims**

1. An Insulated Gate Bipolar Transistor, IGBT, switch circuit, comprising:

   an IGBT circuit (2011, 2012, 2013, 2014, 2015, 2016), comprising an IGBT ($T_{21}$) and a first diode ($d_{21}$), the first diode ($d_{21}$) being connected in parallel with the IGBT ($T_{21}$), the anode of the first diode ($d_{21}$) being connected to the emitter of the IGBT ($T_{21}$) and the cathode of the first diode ($d_{21}$) being connected to the collector of the IGBT ($T_{21}$), the IGBT circuit (2011, 2012, 2013, 2014, 2015, 2016) serving as a modulating switch connected to an electric machine (200) and a load (100) thereof;
   an active clamping protection circuit (P) coupled to the IGBT circuit (2011, 2012, 2013, 2014, 2015, 2016), the protection circuit (P) comprising a transient suppression diode (TVS) and a second diode ($d_{22}$), a cathode of the transient suppression diode (TVS) is coupled to the IGBT ($T_{21}$), an anode of the transient suppression diode (TVS) is connected to an anode of the second diode ($d_{22}$);
   a switch ($S_2$) also being connected between the IGBT circuit (2011, 2012, 2013, 2014, 2015, 2016) and the protection circuit (P), the second diode ($d_{22}$) of the protection circuit (P) being connected to the switch ($S_2$), and a control circuit ($C_2$), which issues a control signal (PWM) to control the opening and closing of the switch ($S_2$), **characterized in that**,
   the control signal (PWM) is a square wave signal of a specific frequency, which controls the switch ($S_2$) to be in a closed state, when the IGBT circuit (2011, 2012, 2013, 2014, 2015, 2016) is switched on, so that the protection circuit (P) operates normally, to maintain the closed state for a time period ($t_3$), when the IGBT circuit (2011, 2012, 2013, 2014, 2015, 2016) is switched off, to ensure that the protection circuit (P) operates normally in order to effectively suppress a spike value ($V_{TR}$), and after the time period ($t_3$), when the IGBT circuit (2011, 2012, 2013, 2014, 2015, 2016) is still switched off, to be in an open state, so that the IGBT circuit (2011, 2012, 2013, 2014, 2015, 2016) is not erroneously switched on, wherein the switch ($S_2$) comprises a PMOS, with a source thereof connected to a cathode of the second diode ($d_{22}$) of the protection circuit, and a drain thereof connected to a gate of the IGBT ($T_{21}$) of the IGBT circuit (2011, 2012, 2013, 2014, 2015, 2016).

2. The IGBT switch circuit as claimed in claim 1, **characterized in that** the IGBT ($T_{21}$) is an N-channel IGBT.

3. The IGBT switch circuit as claimed in claim 1 or 2, **characterized in that** the switch ($S_2$) is also connected to an NMOS ($B_2$), with a drain thereof coupled to a gate of the PMOS serving as the switch ($S_2$), and a source thereof connected to ground.

4. The IGBT switch circuit as claimed in claim 3, **characterized in that** the IGBT switch circuit also comprises a gate level driver connected to a gate of the NMOS ($B_2$), for driving the IGBT circuit.

5. The IGBT switch circuit as claimed in claim 4, **characterized in that** a resistance circuit ($R_2$) is also connected between the gate level driver and the gate of the NMOS ($B_2$), for controlling the drive speed of the IGBT circuit (2011, 2012, 2013, 2014, 2015, 2016).

6. An electric machine system, **characterized in that** the electric machine system comprises an electric machine (200) for driving a load (100), wherein at least three branches (A, B, C) are included, each branch being connected to two parallel-connected IGBT switch circuits according to any one of claims 1 to 5.

7. An electrically driven motor vehicle (100), **characterized in that** it comprises an electric machine system according to claim 6.

**Patentansprüche**

1. IGBT-Schaltkreis (Insulated Gate Bipolar Transistor, Bipolartransistor mit isolierter Gate-Elektrode), umfassend:

   eine IGBT-Schaltung (2011, 2012, 2013, 2014, 2015, 2016), die einen IGBT ($T_{21}$) und eine erste Diode ($d_{21}$) umfasst, wobei die erste Diode ($d_{21}$) mit dem IGBT ($T_{21}$) parallel geschaltet ist, wobei die Anode der ersten Diode ($d_{21}$) mit dem Emitter des IGBT ($T_{21}$) verbunden ist und die Kathode der ersten Diode ($d_{21}$) mit dem

Kollektor des IGBT ($T_{21}$) verbunden ist, wobei der IGBT-Schaltkreis (2011, 2012, 2013, 2014, 2015, 2016) als modulierender Schalter dient, der mit einer elektrischen Maschine (200) und einer Last (100) davon verbunden ist;

eine aktive Klemmschutzschaltung (P), die mit der IGBT-Schaltung (2011, 2012, 2013, 2014, 2015, 2016) gekoppelt ist, wobei die Schutzschaltung (P) eine Diode zur Unterdrückung von Transienten (TVS, Transient Suppression Diode) und eine zweite Diode ($d_{22}$) umfasst, wobei eine Kathode der Diode zur Unterdrückung von Transienten (TVS) mit dem IGBT ($T_{21}$) gekoppelt ist, eine Anode der Diode zur Unterdrückung von Transienten (TVS) mit einer Anode der zweiten Diode ($d_{22}$) verbunden ist;

einen Schalter ($S_2$), der ebenfalls zwischen die IGBT-Schaltung (2011, 2012, 2013, 2014, 2015, 2016) und die Schutzschaltung (P) geschaltet ist, wobei die zweite Diode ($d_{22}$) der Schutzschaltung (P) mit dem Schalter ($S_2$) verbunden ist, und

eine Steuerschaltung ($C_2$), die ein Steuersignal (PWM) ausgibt, um das Öffnen und Schließen des Schalters ($S_2$) zu steuern,

**dadurch gekennzeichnet, dass**

das Steuersignal (PWM) ein Rechtecksignal mit einer bestimmten Frequenz ist, das den Schalter ($S_2$) derart steuert, dass er sich in einem geschlossenen Zustand befindet, wenn die IGBT-Schaltung (2011, 2012, 2013, 2014, 2015, 2016) eingeschaltet ist, so dass die Schutzschaltung (P) normal arbeitet, den geschlossenen Zustand für eine Zeitspanne ($t_3$) aufrechterhält, wenn die IGBT-Schaltung (2011, 2012, 2013, 2014, 2015, 2016) abgeschaltet ist, um sicherzustellen, dass die Schutzschaltung (P) normal arbeitet, um einen Spitzenwert ($V_{tr}$) wirksam zu unterdrücken, und nach der Zeitspanne ($t_3$), wenn die IGBT-Schaltung (2011, 2012, 2013, 2014, 2015, 2016) weiterhin ausgeschaltet ist, sich in einem offenen Zustand befindet, damit die IGBT-Schaltung (2011, 2012, 2013, 2014, 2015, 2016) nicht fälschlicherweise eingeschaltet wird, wobei der Schalter ($S_2$) einen PMOS umfasst, wobei eine Source davon mit einer Kathode der zweiten Diode ($d_{22}$) der Schutzschaltung verbunden ist und ein Drain davon mit einem Gate des IGBT ($T_{21}$) der IGBT-Schaltung (2011, 2012, 2013, 2014, 2015, 2016) verbunden ist.

2. IGBT-Schaltkreis nach Anspruch 1, **dadurch gekennzeichnet, dass** der IGBT ($T_{21}$) ein N-Kanal-IGBT ist.

3. IGBT-Schaltkreis nach Anspruch 1 oder 2, **dadurch gekennzeichnet, dass** der Schalter ($S_2$) auch mit einem NMOS ($B_2$) verbunden ist, wobei ein Drain desselben mit einem Gate des PMOS, der als Schalter ($S_2$) dient, gekoppelt ist und eine Source desselben mit Masse verbunden ist.

4. IGBT-Schaltkreis nach Anspruch 3, **dadurch gekennzeichnet, dass** der IGBT-Schaltkreis auch einen Treiber auf Gate-Ebene umfasst, der mit einem Gate des NMOS ($B_2$) verbunden ist, um die IGBT-Schaltung anzusteuern.

5. IGBT-Schaltkreis nach Anspruch 4, **dadurch gekennzeichnet, dass** auch eine Widerstandsschaltung ($R_2$) zwischen den Treiber auf Gate-Ebene und das Gate des NMOS ($B_2$) geschaltet ist, um die Ansteuergeschwindigkeit der IGBT-Schaltung (2011, 2012, 2013, 2014, 2015, 2016) zu steuern.

6. Elektromaschinensystem, **dadurch gekennzeichnet, dass** das Elektromaschinensystem eine elektrische Maschine (200) zum Antreiben einer Last (100) umfasst, wobei wenigstens drei Zweige (A, B, C) vorhanden sind, wobei jeder Zweig mit zwei parallel geschalteten IGBT-Schaltkreisen gemäß einem der Ansprüche 1 bis 5 verbunden ist.

7. Elektrisch angetriebenes Motorfahrzeug (100), **dadurch gekennzeichnet, dass** es ein Elektromaschinensystem (26) gemäß Anspruch 6 umfasst.

**Revendications**

1. Circuit de commutation à transistor bipolaire à grille isolée, IGBT, comprenant :

un circuit IGBT (2011, 2012, 2013, 2014, 2015, 2016), comprenant un IGBT ($T_{21}$) et une première diode ($d_{21}$), la première diode ($d_{21}$) étant branchée en parallèle à l'IGBT ($T_{21}$), l'anode de la première diode ($d_{21}$) étant branchée à l'émetteur de l'IGBT ($T_{21}$) et la cathode de la première diode ($d_{21}$) étant branchée au collecteur de l'IGBT ($T_{21}$), le circuit IGBT (2011, 2012, 2013, 2014, 2015, 2016) servant de commutateur de modulation branché à une machine électrique (200) et une charge (100) de celle-ci ;

un circuit de protection active à limitation (P) couplé au circuit IGBT (2011, 2012, 2013, 2014, 2015, 2016), le circuit de protection (P) comprenant une diode de suppression des transitoires (TVS) et une deuxième diode

(d$_{22}$), une cathode de la diode de suppression des transitoires (TVS) étant couplée à l'IGBT (T$_{21}$), une anode de la diode de suppression des transitoires (TVS) étant branchée à une anode de la deuxième diode (d$_{22}$) ; un commutateur (S$_2$) également branché entre le circuit IGBT (2011, 2012, 2013, 2014, 2015, 2016) et le circuit de protection (P), la deuxième diode (d$_{22}$) du circuit de protection (P) étant branchée au commutateur (S$_2$) ; et un circuit de commande (C$_2$), qui délivre un signal de commande (PWM) pour commander l'ouverture et la fermeture du commutateur (S$_2$),

**caractérisé en ce que**

le signal de commande (PWM) est un signal à onde carrée d'une fréquence spécifique, qui commande au commutateur (S$_2$) d'être dans un état fermé, quand le circuit IGBT (2011, 2012, 2013, 2014, 2015, 2016) est allumé, de telle sorte que le circuit de protection (P) fonctionne normalement, de rester dans l'état fermé pendant un laps de temps (t$_3$), quand le circuit IGBT (2011, 2012, 2013, 2014, 2015, 2016) est éteint, pour s'assurer que le circuit de protection (P) fonctionne normalement afin de supprimer efficacement une valeur transitoire (V$_{tr}$), et après le laps de temps (t$_3$), quand le circuit IGBT (2011, 2012, 2013, 2014, 2015, 2016) est toujours éteint, d'être dans un état ouvert, de telle sorte que le circuit IGBT (2011, 2012, 2013, 2014, 2015, 2016) n'est pas activé de façon erronée, le commutateur (S$_2$) comprenant un PMOS, avec une source de celui-ci branchée à une cathode de la deuxième diode (d$_{22}$) du circuit de protection, et un drain de celui-ci branché à une grille de l'IGBT (T$_{21}$) du circuit IGBT (2011, 2012, 2013, 2014, 2015, 2016).

2. Circuit de commutation IGBT selon la revendication 1, **caractérisé en ce que** l'IGBT (T$_{21}$) est un IGBT à canal N.

3. Circuit de commutation IGBT selon la revendication 1 ou 2, **caractérisé en ce que** le commutateur (S$_2$) est également branché à un NMOS (B$_2$), avec un drain de celui-ci couplé à une grille du PMOS jouant le rôle du commutateur (S$_2$), et une source de celui-ci branchée à la terre.

4. Circuit de commutation IGBT selon la revendication 3, **caractérisé en ce que** le circuit de commutation IGBT comprend également un dispositif d'excitation de niveau de grille branché à une grille du NMOS (B$_2$), pour exciter le circuit IGBT.

5. Circuit de commutation IGBT selon la revendication 4, **caractérisé en ce qu'**un circuit résistif (R$_2$) est également branché entre le dispositif d'excitation de niveau de grille et la grille du NMOS (B$_2$), pour commander la vitesse d'excitation du circuit IGBT (2011, 2012, 2013, 2014, 2015, 2016).

6. Système de machine électrique, **caractérisé en ce que** le système de machine électrique comprend une machine électrique (200) destinée à exciter une charge (100), dans lequel au moins trois branches (A, B, C) sont incluses, chaque branche étant branchée à deux circuits de commutation IGBT branchés en parallèle selon l'une quelconque des revendications 1 à 5.

7. Véhicule à moteur électrique (100), **caractérisé en ce qu'**il comprend un système de machine électrique selon la revendication 6.

Fig.1

Fig.2

Fig.3

Fig.4

Fig.5

Fig.6

Fig.7

Fig.8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2009296291 A1
- US 2013293287 A1

- US 2006103428 A